**Europäisches Patentamt**

**European Patent Office**

**Office européen des brevets**

(1) Publication number: **0 108 390**
**B1**

## EUROPEAN PATENT SPECIFICATION

(45) Date of publication of patent specification: **09.03.88**

(51) Int. Cl.⁴: **H 01 L 27/10, G 11 C 11/24**

(21) Application number: **83110928.5**

(22) Date of filing: **02.11.83**

(54) **Semiconductor memory.**

(30) Priority: **04.11.82 JP 192478/82**

(43) Date of publication of application:
**16.05.84 Bulletin 84/20**

(45) Publication of the grant of the patent:
**09.03.88 Bulletin 88/10**

(84) Designated Contracting States:
**DE FR GB IT**

(56) References cited:
**WO-A-81/03241**
**DE-A-2 441 385**
**DE-A-2 728 927**

**PATENTS ABSTRACTS OF JAPAN, vol. 7, no.
17(E-154)(1162), 22nd January 1983**

**IBM TECHNICAL DISCLOSURE BULLETIN, vol.
22, no. 8B, January 1980, pages 3683-3687,
New York, USA T.S. CHANG et al.: "Vertical
FET random-access memories with deep
trench isolation"**

(73) Proprietor: **HITACHI, LTD.**
**6, Kanda Surugadai 4-chome Chiyoda-ku
Tokyo 100 (JP)**

(72) Inventor: **Sunami, Hideo
2196-421, Hirai, Hinodemachi
Nishitama-gun Tokyo (JP)**
Inventor: **Kure, Tokuo
1-217-A6, Higashi-koigakubo
Kokubunji-shi Tokyo (JP)**
Inventor: **Kawamoto, Yoshifumi
3511-14, Kawashiri Shiroyama-cho
Tsukui-gun Kanagawa-ken (JP)**
Inventor: **Miyao, Masanobu
1188-5-107, Kamiarai
Tokorozawa-shi Saitama-ken (JP)**

(74) Representative: **Strehl, Peter, Dipl.-Ing. et al
Strehl, Schübel-Hopf, Schulz Patentanwälte
Widenmayerstrasse 17 Postfach 22 03 45
D-8000 München 22 (DE)**

## Description

### Background of the Invention

The present invention relates to a semiconductor memory, and in particular to a one-transistor dynamic MOS memory which enables an increase in memory capacity without increasing the space required, and which is suitable for increasing memory size.

The memory size of MOS dynamic memories quadrupled in the approximately three years after a 1K bit dynamic random access memory (hereinafter referred to as dRAM) was first sold in the early 1970s. 16-pin DIPs (dual inline packages) are mainly used for accommodating memory chips, but this imposes a limitation on the size of the cavity for inserting the chips. Therefore the size of memory chip has increased by approximately 1.4 times, despite the fact that the degree of integration has quadrupled. (Since large quantities of dRAMS are used, it is necessary to curb any increase of the chip size, if only from the standpoint of cost). Therefore, the area of memory cell per bit of one storage unit is greatly reduced, i.e., is reduced to about one-third, owing to the quadrupled degree of integration. The capacity C of a semiconductor memory is expressed by $C = \varepsilon A/T_i$ (where $\varepsilon$ is the permeability of the insulator, A the capacitor area, and $T_i$ the insulator thickness). Therefore, if the area A is reduced to one-third, the capacity C decreases to one-third so long as $\varepsilon$ and $T_i$ remain the same. The signal quantity S of a memory capacitor changes in proportion with the charge quantity Qs stored, and the charge quantity Qs is a product of the capacity C and the memory voltage Vs. Therefore, the charge quantity Qs decreases with a decrease in the capacitor area A, and the signal quantity S decreases correspondingly.

If noise voltage is denoted by N, the signal-to-noise ratio (S/N ratio) decreases with a decrease in the signal quantity S, raising a problem with regard to the operation of the circuit. Usually, therefore, a decrease in the capacitor area A is compensated by decreasing the insulator thickness $T_i$. Therefore, as the degree of integration of dRAMs increases from 4K bit to 16K bit to 64K bit, the typical thickness $T_i$ of the $SiO_2$ film used as the insulator gradually decreases from 100 nm to 75 nm and then to 50 nm.

Recently it has been confirmed that noise results from electric charges of a maximum of approximately 200 fC generated in a silicon substrate by alpha particles radiated from radioactive heavy metals (such as U, Th, etc.) within the package. In order to maintain reliability in operation, therefore, it is not possible to reduce the signal quantity, i.e., the electric charge, to below about 200 fC.

Because of these reasons, therefore, attempts have been made to reduce the thickness of the insulator further, raising a problem with regard to the dielectric breakdown of the insulator. The $SiO_2$ film which is usually used as the insulator of the capacitor has a dielectric withstand electric field of a maximum of $10^7$ V/cm. Therefore, a 10 nm thick $SiO_2$ film will break down permanently, or be degraded, when a voltage of 10 volts is applied. Using such a device close to its maximum dielectric withstand electric field causes a serious problem with regard to its long-term reliability, if it does not break down permanently.

Fig. 1 is a diagram of the construction of a one-transistor dRAM memory cell which consists of a capacitor 1 for storing electric charge, and a switching MOS transistor 2. The drain of the switching MOS transistor is connected to a bit line 3, and its gate is connected to a word line 4.

This memory cell is operated by the reading out of the signal charge stored in the capacitor 1 by the switching MOS transistor 2. In practice, the construction of a large-scale integrated memory is formed of a memory array by methods which can be roughly divided into the two described below.

Fig. 2 shows the so-called "open-bit line" construction in which bit lines 3—1 and 3—2 are arrayed on either side of a sense amplifier 5 which amplifies signals in a differential manner. In this construction, only one bit line, 3—1, electrically crosses one word line 4—1, and the difference in signals between the bit line 3—1 and the bit line 3—2 is detected by the sense amplifier 5.

Fig. 3 illustrates the so-called "folded-bit line" construction in which two bit lines 3—1 and 3—2 connected to the sense amplifier 5 are arrayed in parallel, so that one word line 4—1 intersects both bit lines 3—1 and 3—2.

The embodiment of the present invention described below pertains chiefly to the folded-bit line construction. The invention, however, can also be adapted to the open-bit line construction.

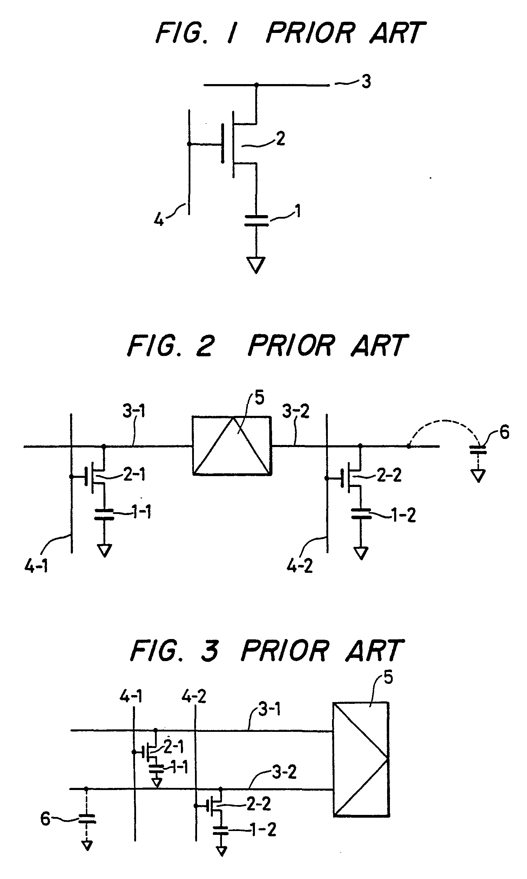

As shown in Figs. 2 and 3, if the stray capacitance of a stray capacitor 6 of the bit line 3—2 is denoted by $C_D$ and the capacity of capacitor 1—2 of the memory cell by $C_S$, one of the main figures of merit of the memory array is expressed by $C_S/C_D$. The S/N ratio of the memory array corresponds exactly to $C_S/C_D$. To improve the S/N ratio, furthermore, it is important to increase the capacity $C_S$ of the capacitor of the memory cell, and reduce the stray capacitance $C_D$ of the bit line 3.

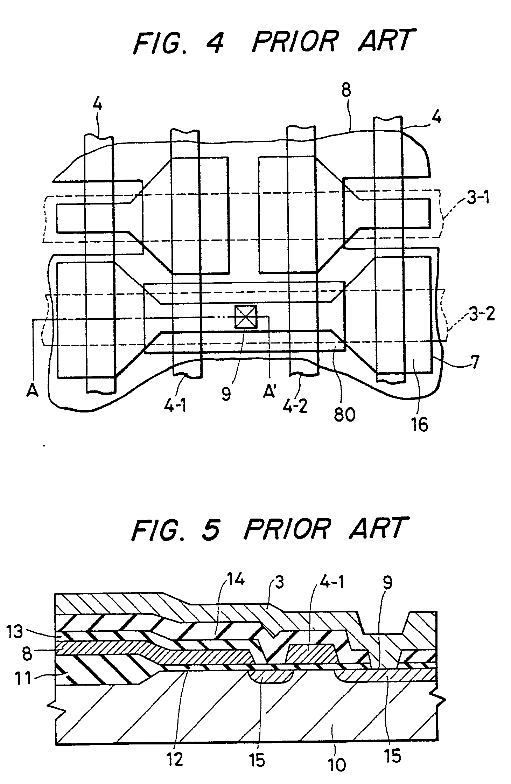

Fig. 4 is a plan view of the construction of a memory cell of the folded-bit line type, and Fig. 5 is a section thereof taken along the line A—A' of Fig. 4. As can be seen from Figs. 4 and 5, a capacitor is formed in a portion of an active region which is surrounded by a field oxidization film 11 of a thickness of usually more than 100 nm. The active region 7 is covered by a plate 8, but the plate 8 is selectively removed from the portion where a switching transistor will be formed and from the portion of a contact hole 9 through which the bit line 3 will be connected to a drain 15 on the silicon substrate (region 80 in Fig. 4). Word lines 4—1 and 4—2 are attached in this portion to form the switching transistor 2.

One method of forming a semiconductor memory of this type is described below. For ease

of comprehension, the transistor described here is of the n-channel type. To form a p-channel transistor, the conductivity types of the silicon substrate and of the diffusion layer should be opposite to those of the n-channel transistor.

In the conventional memory cell shown in Fig. 5, a field $SiO_2$ film 11 is formed selectively to a thickness of usually 100 to 1000 nm on a p-type silicon substrate 10 having a resistivity of about 10 ohms-cm, by the so-called LOCOS method using a thermal oxidation mask composed of $Si_3N_4$. The plate 8 is deposited selectively thereon, the plate 8 being composed of polycrystalline silicon doped with phosphorus or arsenic ions. The surface of the polycrystalline silicon plate 8 is then oxidized to form a first intermediate oxide film 13. The word line 4 is deposited, the word line 4 being composed of polycrystalline silicon, molybdenum silicide, or a refractory metal (molybdenum or tungsten), followed by the implantation of phosphorus or arsenic ions. Thus, $n^+$-type diffusion layers 15 are formed in the active regions where no plate 8 or word line 4 is deposited, to form the source and drain of the switching MOS transistor 2. Thereafter, PSG (phosphosilicate glass) containing phosphorus is deposited to a thickness of 200 to 1000 nm by the so-called CVD method to form a second intermediate insulator 14, a contact hole 9 is formed in the place where the bit line 3 formed by an aluminum electrode is to be connected to the diffusion layer 15, and the bit line 3 is selectively deposited.

In the thus-formed memory cell, the area occupied by the region 16 of the capacitor 1 acting as the memory capacitor inevitably decreases with a decrease in the size of the memory cell. Unless the thickness of the gate oxide film 12 is reduced, therefore, the capacity $C_S$ decreases to raise a serious problem concerning memory operation.

In the above description, the same $SiO_2$ insulation film 12 lies beneath the plate 8 and the word line 4 (i.e., the gate of the switching MOS transistor 2). When it is desired to increase the capacity $C_S$ of the memory cell, however, the insulation film beneath the plate 8 can be formed to have a one- to three-layer construction using either $SiO_2$ or $Si_3N_4$, or both.

To solve the above problems, a memory has been proposed by one of the inventors of the present application, in which a narrow groove is formed in the silicon substrate, and a capacitor that acts as the memory capacitor is formed on the surfaces of the groove (Japanese Laid-Open Patent Application 130,178/1976).

In this memory, the side and bottom surfaces of the groove are utilized as the electrode surfaces of the capacitor, providing the advantage that the electrode area is considerably increased without increasing the space required, compared with the memory of the construction shown in Figs. 4 and 5.

WO 81/03421 discloses a semiconductor memory which is provided with a capacitor formed by utilizing a groove formed in the semiconductor substrate and an insulated-gate field-effect transistor, as well as a process of manufacturing the same. Providing a groove-shaped capacitor makes it possible to increase the degree of integration of a semiconductor integrated circuit. According to WO 81/03421, a plurality of grooves is provided to form a number of individual mesas, each mesa including a single memory cell. The capacitor of the memory cell is formed between a highly-doped conductive layer on the mesa side walls and a conductive filling in the groove separated from the conductive layer by an insulating film. The filling of the groove is of conductive material, and the fillings of the grooves are all interconnected and grounded. The electrode forming conductive layer of each mesa has an impurity type opposite to the substrate and thus a pn-junction is formed between the electrode forming conductive layer and the substrate. α-particles which diagonally transverse the substrate, will create hole-electron pairs in the vicinity of said pn-junction and thus influence the charge stored in the capacitor.

Summary of the Invention

The object of the present invention is to provide a semiconductor memory which has a capacitor with good characteristics, and which requires only a small space.

Another object of the present invention is to provide a method which enables the area of a capacitor to be maintained or increased without reducing the thickness of the insulation film, even when the memory cell is small, yet overcoming the serious problems such as the alpha-particle induced disturbances that arises with a decrease in size of a memory cell, while maintaining high S/N ratio and breakdown voltage.

In order to achieve these objects, one embodiment of the present invention provides a groove-shaped capacitor in which the doped region for forming the first electrode of the capacitor has the conductivity type of the substrate and an impurity concentration which is greater than that of the substrate, and the second electrode of the capacitor formed within the groove is connected to the source or drain of the insulated gate-field effect transistor.

Brief Description of the Drawings

Fig. 1 is a circuit diagram of a conventional memory cell;

Fig. 2 is a circuit diagram of a method of using the conventional memory device;

Fig. 3 is a circuit diagram of another method of using the conventional memory device;

Fig. 4 is a plan view of the conventional memory cell;

Fig. 5 is a section through the conventional memory cell;

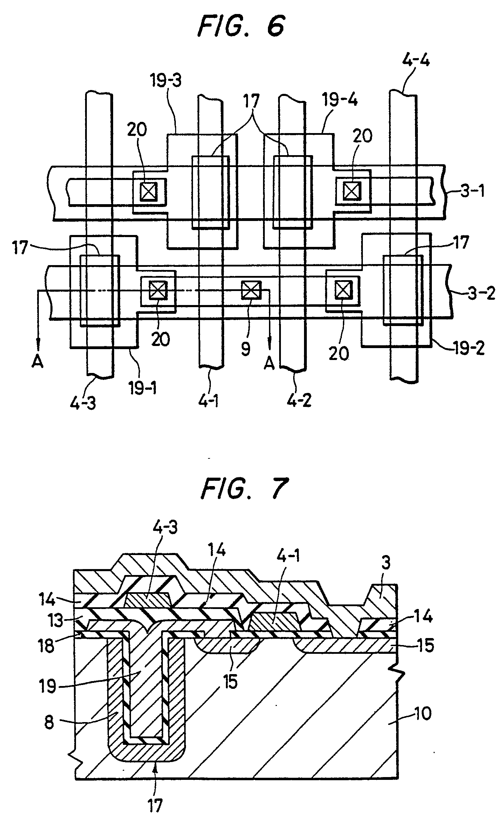

Fig. 6 is a plan view of an embodiment of the present invention;

Fig. 7 is a section through the embodiment of the present invention;

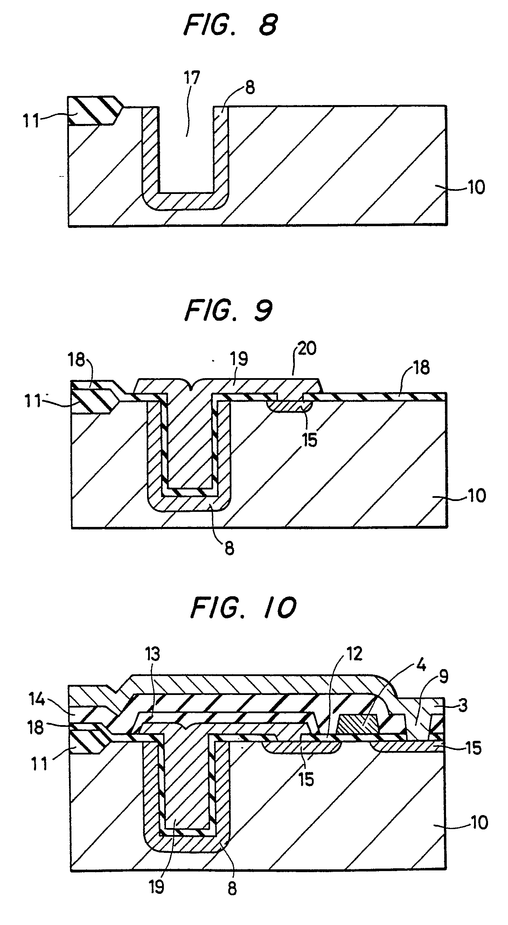

Figs. 8 to 10 are sections illustrating the manufacture steps of an embodiment of the present invention;

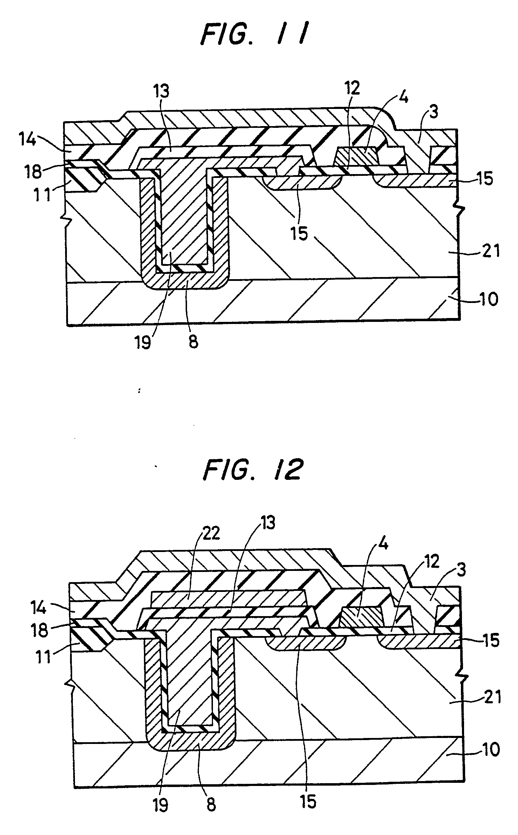

Fig. 11 is a section through another embodiment of the present invention;

Fig. 12 is a section through a third embodiment of the present invention;

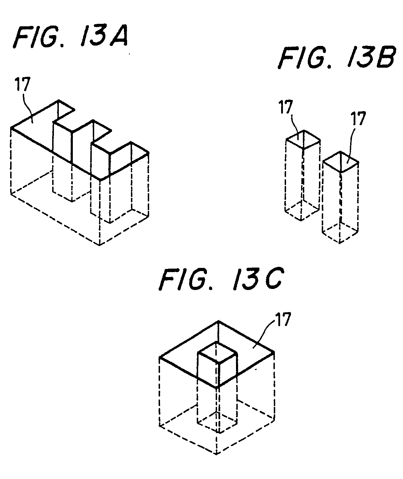

Fig. 13 illustrates capacitor electrodes of various shapes.

Detailed Description of the Invention

According to the present invention, as described above, a memory is provided which has a capacitor in a memory capacitor portion which has an increased capacity without requiring an increase space, and which is hardly affected at all by external noise, the capacitor being constructed within a groove formed in the substrate.

Fig. 6 is a plan view of an embodiment according to the present invention. The difference between this embodiment and the conventional memory cell of Fig. 4 is the formation of a layer with a small resistivity and having the same conductivity type as that of the silicon substrate in the side walls of a groove 17 engraved in the silicon substrate 10, and which is used as a plate 8, and an electrode laid in this groove is used as a capacitor electrode 20.

Fig. 7 is a section taken along the line A—A' of Fig. 6. In Figs. 6 and 7, reference numeral 3 denotes a bit line, 4—1 and 4—3 word lines, 8 a plate, 10 a p-type silicon substrate, 13 a first intermediate insulation film, 14 a second intermediate insulation film, 15 an n-type diffusion layer, 17 a groove, 18 a capacitor insulation film, and 19 a capacitor electrode.

With this construction, the side and bottom surfaces of the groove can be utilized as the capacitor. Therefore, the capacity is increased without increasing the space required.

The steps of manufacturing the semiconductor memory of the invention are described below in detail. First, as illustrated in Fig. 8, a field oxide film 11 is formed by the LOCOS method over the p-type silicon substrate 10 which has a resistivity of 1 to 20 ohms-cm, and a groove 17 of the desired size is formed by parallel-plate plasma etching using a gas containing fluorine or chlorine, such as $SF_6$ or $CCl_4$. The groove is usually etched to a depth of 1 to 5 μm. For this purpose, the pattern of the groove is first transferred onto a CVD $SiO_2$ film using an ordinary photoresist, and the groove 17 is formed using the CVD $SiO_2$ film as a mask. Thereafter, the $p^+$-type layer 8 of the same conductivity type as that of the silicon substrate and having a conductivity of less than one ohm-cm is formed over the side walls and base of the groove by the well-known diffusion method, or the like, to form the plate 8. As shown in Fig. 9, a capacitor insulation film 18 such as a single layer of $SiO_2$ or $Si_3N_4$, or a composite layer thereof, or one of $Ta_2O_5$, is deposited. A capacitor electrode connection hole 20 is formed at a predetermined place in the capacitor insulation film 18 so as to extend to the silicon substrate 10, and a capacitor electrode 19 of polycrystalline silicon is deposited over the predetermined place so that it is connected to the silicon substrate 10 through the connection hole 20. The groove 17 can be filled with polycrystalline silicon 19, as shown in Fig. 9, provided that the polycrystalline silicon 19 has a thickness which is more than one-half the distance between the inner walls of the groove 17. To impart an electrical conductivity, phosphorus or arsenic ions are added to the polycrystalline silicon 19, so that an $n^+$-type diffusion layer 15 is formed within the silicon substrate 10.

Then, as shown in Fig. 10, the polycrystalline silicon 19 is oxidized by dry or wet oxidation at between 800° to 1100°C to form the first intermediate insulation film 13 which is between 100 to 200 nm thick, the gate oxide film 12 is formed to a thickness of between 10 to 50 nm in the area where the switching MOS transistor 2 will be formed, and a gate (word line 4) of polycrystalline silicon, molybdenum silicide, molybdenum, or tungsten, is deposited thereon. Arsenic ions are then implanted to form the $n^+$-type diffusion layer 15.

Thereafter, the second intermediate insulation film 14 of, for example, CVDPSG is deposited, a contact hole 9 is formed so as to come into contact with the $n^+$-type diffusion layer 15, and the bit line 3 of for example, aluminum is deposited.

Accordingly, the capacitor 1 is made up of the capacitor insulation film 18 and two electrodes; the capacitor electrode 19 and the plate 8 on either side of the capacitor insulation film 18. When the plate 8 is p-type, the same as that of the silicon substrate 10, the capacitor electrode 19 has a positive potential. Therefore, the concentration of the p-type impurities must be sufficiently high that the surface of the plate 8 is not depleted at the maximum potential, and no inversion layer is formed. In another embodiment of the present invention in which the plate 8 is n-type, the surface of the plate 8 accumulates even when the capacitor electrode 19 has a positive potential, so that there is no problem. When the plate 8 is n-type, $n^+$-type layers are formed in a separate manner in the vicinities of grooves 17 shown in Fig. 6; i.e., the $n^+$-type layers must be connected. In such a case, therefore, use is made of an n-type silicon substrate, as shown in Fig. 11, and a p-type epitaxial layer is formed over the surface thereof, so that the separately-formed plates 8 are all connected to the n-type silicon substrate 10. The silicon substrate is at ground potential and is hardly affected at all by noise voltages. To manufacture the device, the silicon substrate 10 with the deposited epitaxial layer 21 should be used instead of the silicon substrate of the embodiment of Figs. 8 to 10.

Fig. 12 shows a further embodiment of the present invention. In the previous embodiments, the capacitor 1 is formed between the capacitor electrode 19 and the plate 8. According to this embodiment, however, the capacitor is further formed by depositing a second plate 22 over the first intermediate insulation film 13. In this case, a capacitor is added to the capacitor formed by the plate 8, thus providing a capacitor with a larger capacity. The second plate 22, which is at ground potential, acts as a shield for the capacitor electrode 19, to make a device which is less susceptible to noise.

In the above embodiments, the switching MOS transistor 2 is formed on the surface of the silicon substrate 10 or the epitaxial layer 21. Now a fourth embodiment of the present invention will be described, which however is not shown in the drawings.

As described already for the previous embodiments, the capacitor insulation film 18 is deposited and then a single crystalline silicon film is formed, thereby forming an SOI (silicon-on-insulator) construction which includes places that will become the capacitor electrode 19 and the diffusion layer 15 in subsequent steps. Namely, a polycrystalline or amorphous silicon film is deposited over the whole surface, or over part of the surface, and the whole or part of the surface is heated by a laser beam or by a heater, so that a monocrystalline layer grows on the insulation film after the silicon film melts, or with the silicon film maintained in the solid phase. The mono-crystallization takes place easily if a piece of silicon film of SOI construction is brought into contact with the silicon substrate 10.

Thereafter, a gate oxide film 12 and a gate 4 are deposited on the SOI layer, followed by the formation of an $n^+$-type layer, so that one side acts as the capacitor electrode 19 and the other side as the diffusion layer 15 connected to the bit line 3. The subsequent steps are the same as those of the previous embodiments. In this embodiment, no switching transistor 2 is formed in the silicon substrate 10; i.e., the substrate 10 may be of any conductivity type.

A dynamic memory, in general, has peripheral circuits with various functions formed around the memory cell, and it is difficult to make the whole of the silicon substrate 10 n-type. Therefore the plate 8 is provided, and only the portion of the memory cell need be n-type.

It is also possible to provide the second plate 22 used in the embodiment of Fig. 12.

In these embodiments of the present invention, the groove 17 has a simple rectangular shape, as shown in Fig. 6. Capacity increases with an increase in the surface area of the capacitor electrode 19 facing the plate 8. As shown in Figs. 13A, 13B and 13C, therefore, the capacitor can be increased to more than that of a simple rectangular shape, while maintaining the same space. That is, the capacity can be increased by forming the groove 17 in a comb shape, as shown in Fig. 13A; or by forming two or more small grooves, as shown in Fig. 13B; or by forming an annular groove 17, as shown in Fig. 13C.

The above embodiments are selected from many processes that enable a wide variety of selections. Therefore, individual steps can be replaced by others in a variety of ways. In all the embodiments, however, the common point remains that the side walls of the groove formed in the substrate are utilized as a capacitor part.

In the above embodiments, the word line 4 has the form of a continuous gate within a memory cell array. It is, however, also possible to form polycrystalline silicon transfer gates of switching transistors that are not continuous, but are separate between memory cells, and connect the gates by the word line 4 using new contact holes. This makes it possible to achieve a high switching speed by using polycrystalline silicon gates which have heretofore been evaluated for their reliability, and by utilizing the advantage of the low resistance of aluminum.

As described earlier, the gist of the present invention resides in that the side walls of a groove engraved in a substrate are utilized as a capacitor part. Therefore, the gist of the present invention is not impaired even when a laminated capacitor such as the second plate 22 composed of a poly-crystalline silicon layer, $Si_3N_4$ film, and poly-crystalline silicon layer, which has heretofore been known, is formed over the surface of the substrate except for the groove, and even when the thus-formed capacitor is connected in parallel to the capacitor formed by the side walls to increase the capacity Cs.

Moreover, the switching transistor is formed in the SOI layer parallel to the silicon substrate. It is possible to form a transistor channel 24 in the vertical direction within the SOI layer 23. The vertical junction transistor can be adapted to every kind of memory cell which employs SOI.

As described in the beginning, the invention deals with the use of an n-channel MOS transistor. To form a p-channel transistor, impurities of the opposite conductivity type should be used. Namely, the phosphorus or arsenic ions should be replaced with boron or aluminum ions, and the boron ions should be replaced by phosphorus, arsenic, or antimony ions.

The invention is described above in detail by way of embodiments. That is, when a switching transistor is formed on the surface of a substrate, the capacity Cs can be increased two to three times while maintaining the same required space, compared with that of a conventional memory cell. When the switching transistor is formed in an SOI layer, the capacity Cs can be increased to several times that of a conventional memory cell. In practice, the groove does not have a perfectly rectangular cross-section, but is rounded to some extent. Further, an intended squared shape may often become circular due to a decrease in the resolution of lithography in fine portions. Even in this case, however, the capacity Cs decreases by only 10 to 20%.

The probability of the erroneous operation of a dynamic memory due to alpha particles is reduced by more than 10 times by an increase in capacity Cs of 10%. Therefore, an increase in the capacity Cs by more than twofold helps not only improve the reliability of a memory of the same scale, but also realize a large-scale memory.

In the semiconductor memory of the present invention, furthermore, pairs of electrons and positive holes generated in large amounts by alpha particles within the silicon substrate seldom flow into the capacitor electrode 19 owing to its construction. With a semiconductor memory employing SOI, in particular, pairs of electrons and positive holes are not able to enter the capacitor electrode 19. Accordingly, the semiconductor memory according to the present invention is very stable against alpha particles.

## Claims

1. A semiconductor memory including an insulated gate field effect transistor (2) and a capacitor (1) formed on a semiconductor substrate (10) having a first conductivity type,

said capacitor comprising a first electrode (8) formed as a doped region at the side walls of a groove (17) in said substrate, a first insulating film (18) formed within said groove on said first electrode (8), a second electrode (19) formed in said groove (17) on said insulating film (18), characterized in that

said doped region forming said first electrode (8) has the first conductivity type and an impurity concentration which is greater than that of the substrate (10), and in that the second electrode (19) formed within the groove is connected to the source or the drain (15) of said insulated gate field effect transistor.

2. A semiconductor memory including an insulated gate field effect transistor (2) and a capacitor (1) formed on a semiconductor substrate (10) having a first conductivity type,

said capacitor comprising a first electrode (8) formed as a doped region at the side walls of a groove (17) in an epitaxial layer formed on the substrate, a first insulating film (18) formed within said groove on said first electrode (8), a second electrode (19) formed in said groove on said insulating film (18),

characterized in that said epitaxial layer has the second conductivity type, that said doped region forming said first electrode (8) has the first conductivity type and extends to the substrate and has an impurity concentration which is greater than that of the substrate (10), and in that the second electrode (19) formed within the groove is connected to the source or the drain (15) of said insulated gate field effect transistor.

3. The semiconductor memory of claim 1 or claim 2, characterized in that said region forming said first electrode (8) surrounds the side walls and the bottom of said groove (17).

4. The semiconductor memory of claim 2, characterized in that a plate (22) is provided over said second electrode (19) on an insulating film (13) (Fig. 12).

5. The semiconductor memory according to any of the claims 2 to 4, characterized in that at least a part of the lower portion of said first electrode (8) is connected to the semiconductor substrate (10) of said first conductivity type.

## Patentansprüche

1. Halbleiterspeicher mit einem Feldeffekttransistor (2) mit isoliertem Gate und einem Kondensator (1), die auf einem Halbleitersubstrat (10) eines ersten Leitungstype ausgebildet sind,

wobei der Kondensator eine erste Elektrode (8), die als dotiertes Gebiet an den Seitenwänden einer Nut (17) in dem Substrat ausgebildet ist, einen ersten Isolationsfilm (18), der innerhalb der Nut auf der ersten Elektrode (8) ausgebildet ist, und eine zweite Elektrode (19), die in der Nut (17) auf dem Isolationsfilm (18) ausgebildet ist, aufweist, dadurch gekennzeichnet, daß

das die erste Elektrode bildende dotierte Gebiet den ersten Leitungstyp und eine Störstellenkonzentration besitzt, die größer ist als jene des Substrates (10), und daß die in der Nut ausgebildete zweite Elektrode (19) mit Source oder Drain (15) des Feldeffekttransistors mit isoliertem Gate verbunden ist.

2. Halbleiterspeicher mit einem Feldeffekttransistor (2) mit isoliertem Gate und einem Kondensator (1), die auf einem Halbleitersubstrat (10) des ersten Leitungstyps ausgebildet sind, wobei der Kondensator eine erste Elektrode (8), die als dotiertes Gebiet an den Seitenwänden einer Nut (17) in einer epitaxialen, auf dem Substrat ausgebildeten Schicht ausgebildet ist, einen ersten Isolationsfilm (18), der in der Nut auf der ersten Elektrode (8) gebildet ist, und eine zweite Elektrode (19) aufweist, die in der Nut auf dem Isolationsfilm (18) gebildet ist, dadurch gekennzeichnet, daß die epitaxiale Schicht den zweiten Leitungstyp besitzt, daß das die erste Elektrode (8) bildende dotierte Gebiet den ersten Leitungstyp besitzt, sich bis zum Substrat erstreckt und eine Störstellenkonzentration aufweist, die größer als jene des Substrates (10) ist und daß die innerhalb der Nut gebildete zweite Elektrode (19) mit Source oder Drain (15) des Feldeffekttransistors mit isoliertem Gate verbunden ist.

3. Halbleiterspeicher nach Anspruch 1 oder 2, dadurch gekennzeichnet, daß das die erste Elektrode (8) bildende Gebiet die Seitenwände und den Boden der Nut (17) umgibt.

4. Halbleiterspeicher nach Anspruch 2, dadurch gekennzeichnet, daß sich über der Kondensatorelektrode (19) auf einem Isolationsfilm (13) eine zweite Elektrode (22) befindet.

5. Halbleiterspeicher nach einem der Ansprüche 2 bis 4, dadurch gekennzeichnet, daß wenigstens ein Teil des unteren Abschnittes der ersten Elektrode (8) mit dem Halbleitersubstrat (10) vom ersten Leitungstyp verbunden ist.

## Revendications

1. Mémoire à semiconducteurs comportant un transistor à effet de champ à grille isolée (2) et un condensateur (1), formés sur un substrat semiconducteur (10) possédant un premier type de conductivité, ledit condensateur comportant une première électrode (8) réalisée sous la forme d'une région dopée dans les parois latérales d'une rainure (17) ménagée dans ledit substrat, une première pellicule isolante (18) formée à l'intérieur de ladite rainure sur ladite première électrode (8), et une seconde électrode (19) formée dans ladite rainure (17) sur ladite pellicule isolante (18), caractérisée en ce que ladite région dopée constituant ladite première électrode (8) possède le premier type de conductivité et une concentration en impuretés, qui est supérieure à celle du substrat (10), et en ce que la second électrode (19) formée à l'intérieur de la rainure est raccordée à la source ou au drain (15) dudit transistor à effet de champ à grille isolée.

2. Mémoire à semiconducteurs comportant un transistor à effet de champ à grille isolée (2) et un condensateur (1), formés sur un substrat semiconducteur (10) possédant un premier type de conductivité, ledit condensateur comprenant une première électrode (8) réalisée sous la forme d'une région dopée dans les parois latérales d'une rainure (17) ménagée dans une couche épitaxiale formée sur le substrat, une première pellicule isolante (18) formée à l'intérieur de ladite rainure sur ladite première électrode (8), et une second électrode (19) formée dans ladite rainure sur ladite pellicule isolante (18), caractérisée en ce que ladite couche épitaxiale possède le second type de conductivité, que ladite région dopée constituant ladite première électrode (8) possède le premier type de conductivité et s'étend jusqu'au substrat et possède une concentration d'impuretés qui est supérieure à celle du substrat (10), et en ce que la seconde électrode (19) formée à l'intérieur de la rainure est raccordée à la source ou au drain (15) dudit transistor à effet de champ à grille isolée.

3. Mémoire à semiconducteurs selon la revendication 1 ou 2, caractérisée en ce que ladite région constituant ladite première électrode (8) entoure les parois latérales et le fond de ladite rainure (17).

4. Mémoire à semiconducteurs selon la revendication 2, caractérisée en ce qu'une seconde électrode (22) est prévue au-dessus de ladite électrode (19) du condensateur, sur une pellicule isolante (13) (figure 12).

5. Mémoire à semiconducteurs selon l'une quelconque des revendications 2 à 4, caractérisée en ce qu'au moins un élément de la partie inférieure de ladite première électrode (8) est raccorde au substrat semiconducteur (10) possédant ledit premier type de conductivité.

0 108 390

FIG. 1 PRIOR ART

FIG. 2 PRIOR ART

FIG. 3 PRIOR ART

1

## FIG. 4 PRIOR ART

## FIG. 5 PRIOR ART

# FIG. 6

# FIG. 7

## FIG. 8

## FIG. 9

## FIG. 10

## FIG. II

## FIG. I2

FIG. 13A

FIG. 13B

FIG. 13C